# EUROPÄISCHE PATENTSCHRIFT

(11) **EP 2 130 300 B1**
(45) Veröffentlichungstag und Bekanntmachung des Hinweises auf die Patenterteilung: **01.09.2010**
(21) Anmeldenummer: 08701167.2
(22) Anmeldetag: 19.01.2008
(51) Int. Cl.: H03L 7/081, H03L 7/091

(54) **VERFAHREN ZUR ERZEUGUNG EINER TAKTFREQUENZ**
METHOD FOR GENERATING A CLOCK FREQUENCY
PROCÉDÉ PERMETTANT DE GÉNÉRER UNE FRÉQUENCE D'HORLOGE

(30) Priorität: 26.03.2007 DE 102007014294
(43) Veröffentlichungstag der Anmeldung: 09.12.2009
(73) Patentinhaber: KEYMILE GmbH, 30179 Hannover (DE)
(72) Erfinder: BRATSCHKE, Thomas, 30823 Garbsen (DE); SCHNIEDEWIND, Gerd, 30826 Garbsen (DE)
(74) Vertreter: Döring, Roger
(86) Internationale Anmeldenummer: PCT/EP2008/000395
(87) Internationale Veröffentlichungsnummer: WO 2008/116517

(56) Entgegenhaltungen:
- EP-A- 0 637 137
- EP-A- 0 847 142
- EP-A- 1 032 133
- US-A- 5 126 693

## Beschreibung

Die Erfindung bezieht sich auf ein Verfahren zur Erzeugung einer von einem Referenztakt abhängigen Taktfrequenz, unter Verwendung einer Anordnung, die einen digitalen Phasen-Detektor, ein an denselben angeschlossenes digitales Schleifenfilter und einen mit demselben verbundenen Digital/Analog-Umsetzer aufweist, welche alle mit einem gemeinsamen Takt beaufschlagt werden, bei welcher am Ausgang des Digital/Analog-Umsetzers eine Steuerspannung zur Verfügung steht und bei welcher an den Ausgang des Digital/Analog-Umsetzers ein quarzstabiler, steuerbarer Oszillator angeschlossen ist, der als Ausgangssignal einen der Taktfrequenz entsprechenden lokalen Takt erzeugt, bei welchem dem Phasen-Detektor über einen ersten Eingang als erstes Eingangssignal der Referenztakt und über einen zweiten Eingang als zweites Eingangssignal der lokale Takt aufgegeben werden, bei welchem die relative Phasenlage der beiden Takte im Phasen-Detektor mittels Abtastimpulsen festgestellt wird, deren Abstand voneinander durch den gemeinsamen Takt bestimmt wird, bei welchem eine Abweichung der Phasenlagen durch den Oszillator im Ausgleichssinne geregelt wird und bei welchem vor einem der Eingänge des Phasen-Detektors ein Multiplexer in den Übertragungsweg des jeweiligen ankommenden Eingangssignals eingeschaltet wird, dem das entsprechende Eingangssignal einerseits direkt und andererseits über eine Verzögerungsschaltung zugeführt wird, und von welchem der Referenztakt oder der lokale Takt dem Phasen-Detektor entweder direkt oder verzögert zugeführt wird (EP 1 032 133 A1).

Für Schaltwerke allgemein und Datenübertragungssysteme im besonderen werden für die aktiven Komponenten Taktfrequenzen benötigt. Sie werden beispielsweise durch Phasenregelkreise erzeugt, die unter der Bezeichnung "PLL" (Phase-locked Loop) bekannt sind. Eine solche, analog arbeitende PLL ist beispielsweise von Dr. Roland Best in "Theorie und Anwendungen des Phase-locked Loops", 1987, ISBN 3-85502-132-5 beschrieben.

Eine PLL ist demnach ein Regelsystem, mit welchem das Ausgangssignal eines Oszillators (lokaler Takt) in Frequenz und Phase mit einem Eingangssignal synchronisiert wird. Im synchronisierten Zustand der PLL soll die Phasenverschiebung zwischen dem Eingangssignal und dem Ausgangssignal des Oszillators minimal sein und möglichst gegen Null gehen. Sobald zwischen beiden Signalen eine Phasenverschiebung auftritt, wird der Oszillator so lange nachgeregelt, bis die Phasenverschiebung wieder Null oder minimal ist. Es sind spannungsgesteuerte Oszillatoren (VCO) und stromgesteuerte Oszillatoren (CCO) bekannt. Zur PLL gehören neben dem Oszillator ein Phasen-Detektor und ein Schleifenfilter.

Die PLL arbeitet in analogen Systemen ohne wesentliche Probleme. Entsprechende Schaltungen sind jedoch relativ aufwendig, mit vielen Einzelteilen und einem entsprechend großen Platzbedarf. Es sind daher einfacher aufgebaute digitale Systeme entwickelt worden und auf dem Markt erhältlich, bei denen aber Schwierigkeiten auftreten können, weil es Bereiche gibt, in denen der Phasen-Detektor keine Information über die Phasenabweichung zwischen den beiden zu vergleichenden Signalen liefert. Die Verarbeitung von digitalen Datenströmen in Empfangsschaltungen wird dadurch gestört. Es können Fehlabtastungen auftreten.

Bei dem bekannten Verfahren nach der eingangs erwähnten EP 1 032 133 A1 wird eine PLL verwendet, die einen geringen Phasenfehler hat, so daß Fehlabtastungen weitgehendst ausgeschlossen werden können. Sie weist einen digitalen Phasen-Detektor, ein an denselben angeschlossenes digitales Schleifenfilter und einen mit demselben verbundenen Digital/Analog-Umsetzer auf, welche alle mit einem gemeinsamen Takt beaufschlagt werden. An den Ausgang des Digital/Analog-Umsetzers ist ein quarzstabiler, steuerbarer Oszillator angeschlossen, der als Ausgangssignal einen der zu regelnden, von einem Referenztakt abhängigen Taktfrequenz entsprechenden lokalen Takt erzeugt. Dem Phasen-Detektor wird über einen ersten Eingang als erstes Eingangssignal der Referenztakt und über einen zweiten Eingangs als zweites Eingangssignal der lokale Takt aufgegeben. Die relative Phasenlage der beiden Takte wird im Phasen-Detektor mittels Abtastimpulsen festgestellt, deren Abstand voneinander durch den gemeinsamen Takt bestimmt wird. Vor einem der Eingänge des Phasen-Detektors wird ein Multiplexer in den Übertragungsweg des jeweiligen ankommenden Eingangssignals eingeschaltet, dem das entsprechende Eingangssignal einerseits direkt und andererseits über eine Verzögerungsschaltung zugeführt wird, und von welchem der Referenztakt oder der lokale Takt dem Phasen-Detektor entweder direkt oder verzögert zugeführt wird. Der Phasen-Detektor tastet die Phasenlage der beiden Takte abwechselnd kurz vor und kurz nach der jeweiligen Flanke ab. Trotzdem sind Fehlabtastungen auch bei diesem Verfahren nicht auszuschließen.

Der Erfindung liegt die Aufgabe zugrunde, das eingangs geschilderte Verfahren so zu verbessern, daß eine genauere Regelung der Taktfrequenz in einer digital arbeitenden PLL erreicht werden kann, so daß Fehlabtastungen ausgeschlossen werden können.

Diese Aufgabe wird gemäß der Erfindung dadurch gelöst,
- daß als gemeinsamer Takt ein vom Referenztakt und vom lokalen Takt unabhängiger Systemtakt verwendet wird, dessen Frequenz um einen Faktor von mindestens "5" höher als die Frequenz des Referenztaktes bzw. des lokalen Taktes ist, und
- daß der zeitliche Abstand zwischen den Flanken des unverzögerten Takts einerseits und des verzögerten Takts andererseits größer als der zeitliche Abstand der vom Systemtakt vorgegebenen Abtastimpulse des Phasen-Detektors (PD) eingestellt wird.

Mit diesem Verfahren werden der Referenztakt oder der lokale Takt, in an sich bekannter Weise, dem Multiplexer einerseits direkt und andererseits verzögert zugeführt. Am Ausgang des Multiplexers, der mit dem Phasen-Detektor verbunden ist, steht dann beispielsweise abwechselnd der jeweilige Takt direkt oder verzögert an. Die ansteigende Flanke des Takts liegt dementsprechend wechselweise in unterschiedlichen zeitlichen Abständen vor, deren Länge größer sein muß, als die zeitlichen Abstände zwischen den Abtastimpulsen des Phasen-Detektors.

Die Abstände zwischen den Abtastimpulsen des Phasen-Detektors sind bei Anwendung dieses Verfahrens durch den gegenüber Referenztakt und lokalem Takt zumindest um den Faktor "5" höheren Systemtakt bestimmt. Es erfolgt somit durch den Phasen-Detektor eine Art "Überabtastung", wobei mit jeder steigenden Flanke des Systemtaktes Werte der an den beiden Eingängen anstehenden Takte in den Phasen-Detektor eingelesen und verarbeitet werden. Diese durch den Systemtakt bestimmten Abtastflanken haben einen so geringen Abstand voneinander, daß die Flanken der an den beiden Eingängen des Phasen-Detektors abstehenden Takte nicht verpaßt werden können. Bei Einsatz dieses Verfahrens erhält der Phasen-Detektor ohne Unterbrechung Informationen über eine mögliche Phasenverschiebung zwischen Referenztakt und lokalem Takt. Die Genauigkeit der Taktfrequenz für ein zu versorgendes Datenübertragungssystem ist dementsprechend verbessert, weil der Oszillator Differenzen in der Phase von Referenztakt und lokalem Takt schneller folgen kann.

An den Multiplexer kann zusätzlich ein Jittergenerator angeschlossen werden, der mit einem Mikroprozessor und einem Zufallsgenerator ausgerüstet ist, die beide an einen mit dem Multiplexer verbundenen Komparator angeschlossen sind. Durch den Jittergenerator kann die Abfolge von unverzögertem und verzögertem Takt zufällig gestaltet werden. Mittels des Mikroprozessors kann die am Ausgang des Digital/Analog-Umsetzers anstehende Taktfrequenz auch ganz gezielt zwischen zwei Abtastimpulsen festgelegt werden. Dem Jittergenerator wird ebenfalls der Systemtakt aufgegeben, der die Arbeitsweise aller Teile der PLL bestimmt.

Das Verfahren nach der Erfindung wird anhand der Zeichnungen in Ausführungsbeispielen erläutert.

Es zeigen:
Fig. 1 ein Blockschaltbild einer Anordnung zur Durchführung des Verfahrens nach der Erfindung.
Fig. 2 und 3 zwei unterschiedliche Ausführungsformen eines Elements der Anordnung nach Fig. 1 in vergrößerter Darstellung, ebenfalls als Blockschaltbilder.
Fig. 4 Ausschnitte von bei Einsatz des Verfahrens auftretenden Kurvenverläufen.

Die bei diesem Verfahren eingesetzte Verzögerungsschaltung kann entweder in den Übertragungsweg des Referenztakts oder in den Übertragungsweg des vom Oszillator gelieferten lokalen Takts eingeschaltet werden. Im folgenden wird die Version "Einschaltung in den Übertragungsweg des Referenztakts" beschrieben. Die andere Version gilt analog dazu.

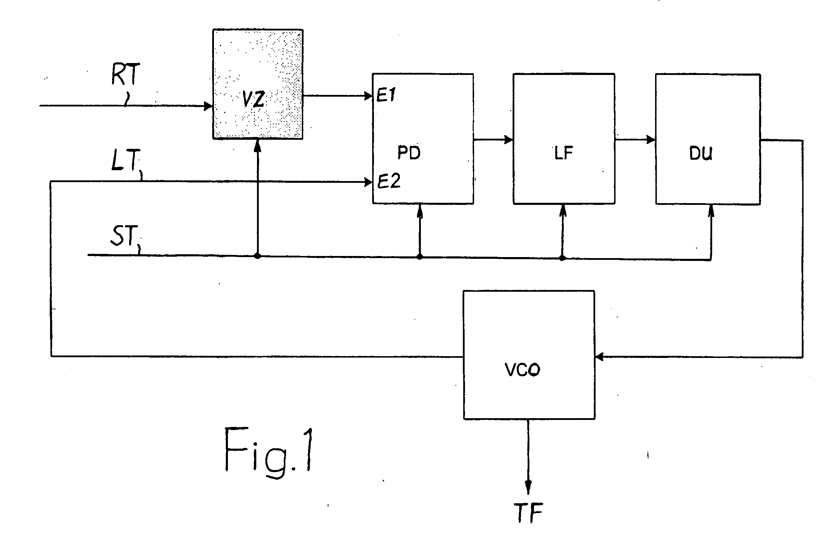

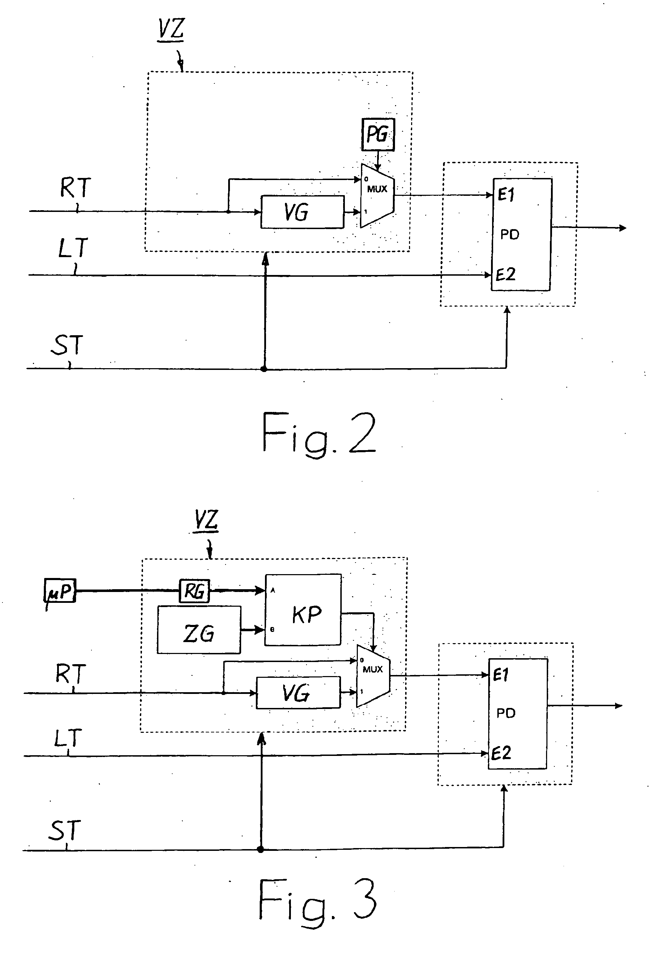

Zu dem in Fig. 1 dargestellten Phasenregelkreis gehören ein digitaler Phasen-Detektor PD, ein an denselben angeschlossenes digitales Schleifenfilter LF, ein mit demselben verbundener Digital/Analog-Umsetzer DU und ein quarzstabiler, steuerbarer Oszillator VCO. Am Ausgang des DUs, mit dem der VCO verbunden ist, steht eine Steuerspannung an. Der VCO liefert als Ausgangssignal einen der zu erzeugenden Taktfrequenz TF entsprechenden lokalen Takt LT. Der LT wird dem PD als zweites Eingangssignal über einen zweiten Eingang E2 zugeführt. Ein den Referenztakt RT repräsentierendes erstes Eingangssignal wird dem PD über dessen ersten Eingang E1 zugeführt, und zwar über eine Verzögerungsschaltung VZ, die in den Fig. 2 und 3 in zwei unterschiedlichen Ausführungsformen genauer dargestellt ist. Die aufgeführten Einheiten des Phasenregelkreises werden - bis auf den VCO - mit einem Systemtakt ST beaufschlagt, der beispielsweise von einem Quarzoszillator erzeugt wird. Die Frequenz des STs ist mindestens um den Faktor "5" höher als die Frequenz der Takte RT und LT. Je höher die Frequenz des STs ist - mit einer sinnvollen bzw. praktikablen Obergrenze -, desto präziser arbeitet das Verfahren nach der Erfindung.

Die VZ weist gemäß Fig. 2 einen Multiplexer MUX auf, dem der RT auf einem ersten Weg direkt und auf einem zweiten Weg über ein Verzögerungsglied VG verzögert zugeführt wird. Der MUX wird von einem Takt- bzw. Pulsgenerator PG gesteuert. Der PG liefert Impulse - "1" oder "O" -, deren Reihenfolge beispielsweise durch einen an den PG angeschlossenen Mikroprozessor einstellbar ist. Am Ausgang des MUX, der mit dem ersten Eingang E1 des PDs verbunden ist, steht entweder der unverzögerte oder der verzögerte RT an. Welche dieser beiden Formen des RTs am Ausgang des MUX ansteht und in welcher Abfolge, wird vom PG entschieden. In einfachster Ausführung werden die beiden Formen regelmäßig wechselnd durchgelassen, so daß die Flanken des RTs abwechselnd einmal unverzögert und einmal verzögert am Eingang E1 des PDs anstehen. Es können aber durch den PG auch andere Abfolgen am MUX eingestellt werden. So kann die unverzögerte Flanke beispielsweise jeweils dreimal hintereinander vom MUX geliefert werden mit einer Unterbrechung durch eine verzögerte Flanke.

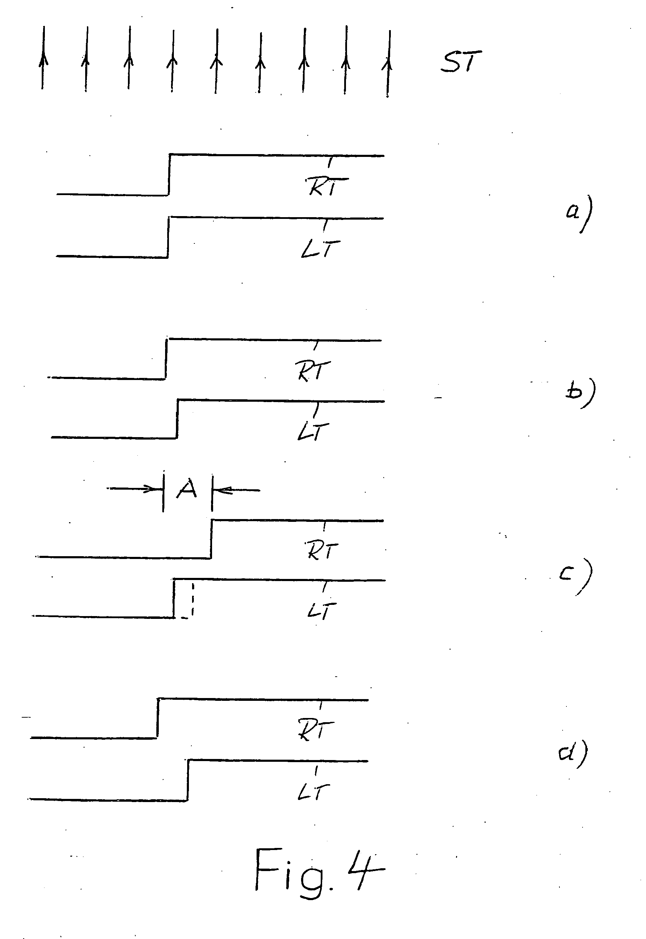

Das Verfahren nach der Erfindung wird im folgenden für die Schaltung nach Fig. 2 anhand der in Fig. 4 dargestellten Kurvenverläufe erläutert:

Der Systemtakt ST ist in Fig. 4 oben durch Pfeile angedeutet. Er hat eine um einen Faktor von mindestens "5" höhere Frequenz als der RT. Die Frequenz des STs beträgt in einer praktischen Anwendung beispielsweise 66 MHz mit einer Taktperiode von 16 nsec. Die Frequenz des RTs und damit auch die des LTs liegt beispielsweise bei 1 MHz mit einer Taktperiode von 1 µsec.

Bei den in Fig. 4a dargestellten Phasenlagen stimmen die Flanken von RT und LT zeitlich überein. Sie werden so beide durch die Abtastimpulse des PDs von diesem erkannt. Es muß nichts ausgeregelt werden. Die TF erfüllt die Anforderungen. Wenn die Phase des LTs mit ihrer Flanke gemäß Fig. 4b gegenüber der Phasenlage des RTs verschoben wäre, würde das bei Schaltungsanordnungen in herkömmlicher Technik vom PD zwar erkannt werden, allerdings ohne Information darüber, in welche Richtung und um welchen Betrag eine Verschiebung stattgefunden hat. Die TF wäre gestört.

Um diese Informationslücke zu schließen und die Gefahr einer entsprechenden Störung zumindest zu verringern, wird der RT dem PD gemäß der eingangs erwähnten EP 1 032 133 A1 in vorgebbarer oder auch zufälliger Reihenfolge unverzögert und verzögert zugeführt. Die Phasenlage bzw. Flanke des RTs "springt" dann in dem in Fig. 4c eingezeichneten Bereich A hin und her. Entsprechend Fig. 4c wird der RT dem PD verzögert zugeführt, und zwar mit einer zeitlichen Verzögerung, die größer als der zeitliche Abstand der Abtastimpulse des STs voneinander ist. Der PD erkennt dann eine "O" des RTs und eine "1" des LTs, mit der Information, daß der LT zu schnell ist, also verzögert werden muß. Die entsprechende Information wird über das LF und den DU an den VCO gegeben, durch welchen der LT entsprechend verzögert wird. Die durch die korrigierte Phasenlage verschobene Flanke des LTs ist in Fig. 4c gestrichelt eingezeichnet.

Wenn bei dieser Phasenlage des LTs gemäß Fig. 4d ein unverzögerter RT am PD anliegt, dann wird von diesem erkannt, daß der LT zu langsam ist. Der VCO erhält also die Information, daß der LT wieder in Richtung "schneller" in der Phase verschoben werden muß.

Auf diese Weise wird die Phasenlage des LTs - bedingt durch die hohe Anzahl von Abtastimpulsen des LTs - in eine stabile Lage gebracht, die zwar von der Phasenlage des RTs abweicht, aber im Ergebnis zu einer stabilen TF am Ausgang des VCOs führt. Das Verfahren ist nicht dadurch begrenzt, daß der RT dem Eingang E1 des PDs abwechselnd unverzögert oder verzögert zugeführt wird, sondern er kann dem Eingang E1 auch in einer variablen, durch den PG vorgebbaren Reihenfolge mit beispielsweise dreimal verzögert und einmal unverzögert aufgegeben werden.

Die Abfolge von unverzögertem und verzögertem RT kann darüber hinaus gemäß Fig. 3 durch einen Jittergenerator gesteuert werden, der einen Zufallsgenerator ZG, einen Mikroprozessor µP und einen Komparator KP umfaßt. ZG und µP sind an unterschiedliche Eingänge des KP angeschlossen, der mit seinem Ausgang mit dem MUX verbunden ist. Der ZG liefert in zufälliger Abfolge Zahlenwerte, beispielsweise zwischen 0 und 63. Sie werden im KP mit einem Zahlenwert verglichen, der vom µP bzw. von einem zwischengeschalteten Register RG aufgegeben wird, in welches der µP den jeweiligen Zahlenwert einschreibt. Je nach dem, ob der Zahlenwert des ZG größer/gleich oder kleiner als der Zahlenwert des µP ist, steht am Ausgang des KP eine "1" oder ein "O" an. Diese Ausgangswerte des KPs steuern den MUX, der dadurch den RT verzögert oder unverzögert dem PD aufgibt.

Wenn sich bei dieser Schaltung beispielsweise - zufällig - eine Abfolge von 1 : 1 für den verzögerten und den unverzögerten RT ergibt, dann liegt die zu regelnde TF in der Mitte zwischen zwei Abtastimpulsen des PDs. Durch Veränderung des dem KP vom µP aufgegebenen Zahlenwerts kann diese Phasenlage der TF zwischen zwei Abtastimpulsen gezielt auf einen anderen stabilen Wert verschoben werden. Das kann mit Vorteil zum Ausgleich der Fertigungstoleranzen von Chargen von Bauteilen ausgenutzt werden, die in einem durch die TF zu versorgenden Datenübertragungssystem eingesetzt werden.

## Patentansprüche

1. Verfahren zur Erzeugung einer von einem Referenztakt (RT) abhängigen Taktfrequenz (TF), unter Verwendung einer Anordnung, die einen digitalen Phasen-Detektor (PD), ein an denselben angeschlossenes digitales Schleifenfilter (LF) und einen mit demselben verbundenen Digital/Analog-Umsetzer (DU) aufweist, welche alle mit einem gemeinsamen Takt beaufschlagt werden, bei welcher am Ausgang des Digital/Analog-Umsetzers eine Steuerspannung zur Verfügung steht und bei welcher an den Ausgang des Digital/Analog-Umsetzers ein quarzstabiler, steuerbarer Oszillator (VCO) angeschlossen ist, der als Ausgangssignal einen der Taktfrequenz entsprechenden lokalen Takt erzeugt, bei welchem dem Phasen-Detektor über einen ersten Eingang als erstes Eingangssignal der Referenztakt und über einen zweiten Eingang als zweites Eingangssignal der lokale Takt aufgegeben werden, bei welchem die relative Phasenlage der beiden Takte im Phasen-Detektor mittels Abtastimpulsen festgestellt wird, deren Abstand voneinander durch den gemeinsamen Takt bestimmt wird, bei welchem eine Abweichung der Phasenlagen durch den Oszillator im Ausgleichssinne geregelt wird und bei welchem vor einem der Eingänge des Phasen-Detektors ein Multiplexer in den Übertragungsweg des jeweiligen ankommenden Eingangssignals eingeschaltet wird, dem das entsprechende Eingangssignal einerseits direkt und andererseits über eine Verzögerungsschaltung zugeführt wird, und von welchem der Referenztakt oder der lokale Takt dem Phasen-Detektor entweder direkt oder verzögert zugeführt wird, **dadurch gekennzeichnet,**
- **daß** als gemeinsamer Takt ein vom Referenztakt (RT) und vom lokalen Takt (LT) unabhängiger Systemtakt (ST) verwendet wird, dessen Frequenz um einen Faktor von
- mindestens "5" höher als die Frequenz des Referenztaktes bzw. des lokalen Taktes ist, und
- **daß** der zeitliche Abstand zwischen den Flanken des unverzögerten Takts einerseits und des verzögerten Takts andererseits größer als der zeitliche Abstand der vom Systemtakt vorgegebenen Abtastimpulse des Phasen-Detektors (PD) eingestellt wird.

2. Verfahren nach Anspruch 1, **dadurch gekennzeichnet, daß** der jeweilige Takt dem Phasen-Detektor (PD) im regelmäßigen Wechsel entweder direkt oder verzögert zugeführt wird.

3. Verfahren nach Anspruch 1, **dadurch gekennzeichnet, daß** der jeweilige Takt dem Phasen-Detektor (PD) in variabler Abfolge direkt oder verzögert zugeführt wird.

4. Verfahren nach Anspruch 1, **dadurch gekennzeichnet, daß** der Multiplexer mit einem Komparator (KP) verbunden wird, an den über zwei getrennte Eingänge ein Zufallsgenerator (ZG) und ein Mikroprozessor (µP) angeschlossen sind.

## Claims

1. A method for generating a clock frequency (TF) dependent on a reference clock signal (RT), using an arrangement which has a digital phase detector (PD), a digital loop filter (IF) connected to the latter, and a digital/analog converter (DU) connected to the latter, to all of which a common clock signal is applied, in which a control voltage is available at an output of the digital/analog converter and in which a quartz-stable, controllable oscillator (VCO) is connected to the output of the digital/analog converter, which oscillator generates as an output signal a local clock signal corresponding to the clock frequency, in which the phase detector is fed the reference clock signal as first input signal via a first input and the local clock signal as second input signal via a second input, in which the relative phase angle of the two clock signals is as certained in the phase detector by means of sampling pulses whose spacing from one another is determined by the common clock signal, in which a deviation of the phase angles is regulated by the oscillator in the sense of compensation and in which, up stream of one of the inputs of the phase detector, a multiplexer is connected into the transmission path of the respective incoming input signal, to which the corresponding input signal is fed directly, on the one hand, and via a delay circuit, on the other hand, and by which the reference clock signal or the local clock signal is fed to the phase detector either directly or in delayed fashion, **characterized in**
- **that** the common clock signal used is a system clock signal (ST) which is independent of the reference clock signal (RT) and of the local clock signal (LT) and whose frequency is higher by a factor of at least "5" than the frequency of the reference clock signal or of the local clock signal, respectively, and
- **that** the temporal spacing between the edges of the unde layed clock signal, on the one hand, and of the delayed clock signal, on the other hand, is set such that the temporal spacing is greater than the temporal spacing of the sampling pulses of the phase detector (PD) that are predetermined by the system clock signal.

2. A method according to claim 1, **characterized in that** the respective clock signal is fed to the phase detector (PD) either directly or in delayed fashion in regular alternation.

3. A method according to claim 1, **characterized in that** the respective clock signal is fed to the phase detector (PD) directly or in delayed fashion in variable sequence.

4. A method according to claim 1, **characterized in that** the multiplexer is connected to a comparator (KP), to which a random generator (ZG) and a microprocessor (µP) are connected via two separate inputs.

## Revendications

1. Procédé pour générer une fréquence d'horloge dépendante d'une horloge de référence en utilisant un arrangement, lequel présente un détecteur de phase numérique, un filtre en boucle numérique raccordé à celui-ci et un convertisseur numérique/analogique relié avec celui-ci, à tous lesquels est appliquée une horloge commune, selon lequel une tension de commande est disponible à la sortie du convertisseur numérique/analogique et selon lequel un oscillateur commandable stabilisé par quartz est raccordé à la sortie du convertisseur numérique/analogique, lequel génère comme signal de sortie une horloge locale correspondant à la fréquence d'horloge, selon lequel l'horloge de référence est délivrée au détecteur de phase par le biais d'une première entrée sous la forme d'un premier signal d'entrée et l'horloge locale par le biais d'une deuxième entrée sous la forme d'un deuxième signal d'entrée, selon lequel la phase relative des deux horloges est déterminée dans le détecteur de phase au moyen d'impulsions d'échantillonnage dont l'écart réciproque est déterminé par l'horloge commune, selon lequel un écart de phase est régulé par l'oscillateur dans le sens d'un équilibrage et selon lequel un multiplexeur est connecté avant l'une des entrées du détecteur de phase, dans le trajet de transmission du signal d'entrée arrivant respectif, auquel le signal d'entrée correspondant est acheminé d'un côté directement et de l'autre côté par le biais d'un circuit de retard et depuis lequel l'horloge de référence ou l'horloge locale est acheminée au détecteur de phase soit directement, soit avec un retard, **caractérisé en ce**
- **que** l'horloge commune utilisée est une horloge système indépendante de l'horloge de référence et de l'horloge locale, dont la fréquence est supérieure d'un facteur d'au moins « 5 » à la fréquence de l'horloge de référence ou de l'horloge locale, et
- **que** l'écart dans le temps entre les fronts de l'horloge non retardée d'un côté et l'horloge retardée de l'autre côté est réglé à une valeur supérieure à l'écart dans le temps entre les impulsions d'échantillonnage du détecteur de phase (PD) prédéfinies par l'horloge système.

2. Procédé selon la revendication 1, **caractérisé en ce que** l'horloge respective est acheminée au détecteur de phase (PD) en alternances régulières soit directement, soit retardée.

3. Procédé selon la revendication 1, **caractérisé en ce que** l'horloge respective est acheminée au détecteur de phase (PD) selon une séquence variable soit directement, soit retardée.

4. Procédé selon l'une des revendications 1 à 3, **caractérisé en ce que** le multiplexeur est relié à un comparateur (KP) auquel sont raccordés, par le biais de deux entrées séparées, un générateur de nombres aléatoires (ZG) et un microprocesseur (µP).
